# EUROPÄISCHE PATENTSCHRIFT

(11) **EP 1 787 337 B1**
(45) Veröffentlichungstag und Bekanntmachung des Hinweises auf die Patenterteilung: **14.03.2018**
(21) Anmeldenummer: 05776778.2
(22) Anmeldetag: 02.08.2005
(51) Int. Cl.: H01L 33/58, H01L 31/0203, H01L 33/48, H01L 31/0232

(54) **BAUELEMENT MIT EINEM OPTOELEKTRONISCHEN BAUTEIL UND EINER VORRICHTUNG**
MODULE WITH AN OPTOELECTRONIC COMPONENT AND A DEVICE
MODULE CONSTITUE D'UN COMPOSANT OPTOELECTRONIQUE ET D'UN DISPOSITIF

(30) Priorität: 23.08.2004 DE 102004040763; 21.10.2004 DE 102004051379
(43) Veröffentlichungstag der Anmeldung: 23.05.2007
(73) Patentinhaber: OSRAM Opto Semiconductors GmbH, 93055 Regensburg (DE)
(72) Erfinder: BOGNER, Georg, 93138 Lappersdorf (DE); HIEGLER, Michael, 73557 Mutlangen (DE); ROSE, Monika, 93049 Regensburg (DE); WAITL, Günter, 93049 Regensburg (DE); WOLF, Manfred, 94356 Kirchroth (DE)
(74) Vertreter: Epping - Hermann - Fischer
(86) Internationale Anmeldenummer: PCT/DE2005/001363
(87) Internationale Veröffentlichungsnummer: WO 2006/021179

(56) Entgegenhaltungen:
- EP-A- 0 585 186
- US-A- 3 887 803
- US-A- 6 117 193
- US-A1- 2003 160 314
- US-A1- 2004 183 081
- US-B1- 6 204 523
- US-B1- 6 610 563
- US-E1- R E37 554
- PATENT ABSTRACTS OF JAPAN Bd. 2003, Nr. 10, 8. Oktober 2003 (2003-10-08) -& JP 2003 163382 A (MATSUSHITA ELECTRIC IND CO LTD), 6. Juni 2003 (2003-06-06)
- PATENT ABSTRACTS OF JAPAN Bd. 1998, Nr. 14, 31. Dezember 1998 (1998-12-31) -& JP 10 233532 A (HOUSHIN KAGAKU SANGIYOUSHIYO:KK), 2. September 1998 (1998-09-02)

## Beschreibung

Die Erfindung betrifft ein Bauelement mit einer Vorrichtung und einem optoelektronischen Bauteil.

Zur Strahlformung bei herkömmlichen optoelektronischen Bauteilen wird einem Halbleiterchip des Bauteils häufig eine Linse nachgeordnet. So wird diese Linse beispielsweise auf einen den Halbleiterchip schützenden Verguss geklebt. Eine derartige Klebeverbindung ist aber häufig gegenüber Verformungen des Vergusses oder Strahlungseinwirkung nicht stabil, so dass die Gefahr einer verschlechterten optischen Anbindung des optischen Elements an den Halbleiterchip erhöht ist. Weiterhin degradieren bei herkömmlichen optoelektronischen Bauteilen eingesetzte Linsen oftmals unter kurzwelliger, insbesondere ultravioletter oder blauer, Strahlung, was sich beispielsweise durch Trübungen, Verfärbungen oder Verformungen der Linse äußern kann.

In der Druckschrift US 2003/0160314 A1 ist ein Gehäuse für einen Halbleiterchip angegeben.

Die Druckschrift EP 0 585 186 A2 betrifft eine Hausung für ein optisches Bauteil.

Eine optische Verkapselung und eine Hausung sind in der Druckschrift US 6,204,523 B1 beschrieben.

Eine oberflächenmontierbare optoelektronische Komponente ist in der Druckschrift US 6,610,563 B1 offenbart.

In der Druckschrift US RE37,554 E ist eine Herstellungsmethode für eine optoelektronische Halbleiterkomponente aufgezeigt.

Die Druckschrift JP 2003-163382 A betrifft eine Hausung für ein Halbleiterelement.

Aus der Druckschrift US 6 117 193 A ist eine Kamera mit einer Linsenhalterung, welche einen Rahmen und Steckelemente aufweist, bekannt.

Eine Aufgabe der Erfindung ist es, ein Bauelement mit einer Vorrichtung zur Befestigung eines optischen Elements anzugeben.

Diese Aufgabe wird durch ein Bauelement mit den Merkmalen des Patentanspruchs 1 gelöst. Vorteilhafte Ausgestaltungen und Weiterbildungen der Erfindung sind Gegenstand der abhängigen Ansprüche.

Eine Vorrichtung umfasst mindestens ein Befestigungselement, wobei das Befestigungselement zur Befestigung der Vorrichtung an einem Gehäusekörper eines optoelektronischen Bauteils vorgesehen ist und die Vorrichtung als Halterung für ein separates optisches Element ausgebildet ist.

Eine derartige Vorrichtung erleichtert mit Vorteil die Befestigung des optischen Elements zur Strahlformung am Gehäusekörper des optoelektronischen Bauteils mittels der Vorrichtung und das optische Element kann vergleichsweise frei gewählt werden. Insbesondere können auf diese Weise optische Elemente mit einer vorteilhaft hohen Stabilität gegenüber kurzwelliger, insbesondere blauer oder ultravioletter, Strahlung vereinfacht bei optoelektronischen Bauteilen eingesetzt werden. Insbesondere kann das optische Element stabil gegenüber Strahlung sein, für deren Erzeugung oder zu deren Empfang das optoelektronische Bauteil vorgesehen ist.

Es können insbesondere optische Elemente Anwendung finden, die Materialien enthalten, welche herkömmlicherweise als zusammen mit optoelektronischen Bauteilen, etwa für kurzwellige Strahlung ausgebildeten Bauteilen, schwierig einsetzbar - z.B. hinsichtlich der Befestigung am Bauteil und gleichzeitiger Strahlungsstabilität - gelten. Bei herkömmlichen Bauelementen müssen deshalb, im Gegensatz zur Erfindung, bei der Auswahl des optischen Elements oftmals Kompromisse eingegangen werden.

Das optische Element wird von der Vorrichtung gehalten, die wiederum am Gehäusekörper des optoelektronischen Bauteils befestigt ist. Die Vorrichtung kann somit speziell als Halterung oder zur Befestigung an dem Gehäusekörper und das optische Element zur Strahlformung von einem Halbleiterchip, z.B. einem Photodiodenchip oder einem LED-Chip, des optoelektronischen Bauteils zu empfangender oder zu erzeugender Strahlung optimiert sein.

In einer bevorzugten Ausgestaltung der Erfindung ist das optische Element und/oder die Vorrichtung formstabil unter Einwirkung kurzwelliger Strahlung. Insbesondere kann das optische Element derartig stabil gegenüber Strahlung sein, für deren Erzeugung oder zu deren Empfang das optoelektronische Bauteil vorgesehen ist.

In einer weiteren bevorzugten Ausgestaltung der Erfindung ist das optische Element unter Strahlungseinwirkung, insbesondere kurzwelliger Strahlung, stabil gegenüber Trübungen oder Verfärbungen, die bei herkömmlichen optischen Elementen oftmals aufgrund einer Einwirkung energiereicher kurzwelliger Strahlung auftreten. Insbesondere kann das optische Element derartig stabil gegenüber Strahlung sein, für deren Erzeugung oder zu deren Empfang das optoelektronische Bauteil vorgesehen ist.

Insbesondere kann das optische Element gegenüber einer dauerhaften Einwirkung kurzwelliger Strahlung vergleichsweise hoher Intensität, die z.B. bei Hochleistungs-Lumineszenzdioden-Bauteilen auftreten können, stabil ausgebildet sein. Die Gefahr einer strahlungsbedingten Änderung der Strahlformungseigenschaften oder der Transmission des optischen Elements kann so insgesamt - über die Betriebsdauer des optoelektronischen Bauteils - verringert werden.

In einer weiteren bevorzugten Ausgestaltung der Erfindung enthält das optische Element ein Glas, ein Epoxidmaterial, ein Thermoplast, ein Polymer, oder Urethan. Polymerhaltige Elemente können beispielsweise als eine Mehrzahl von auf einem Träger, vorzugsweise einem Glasträger, angeordneten Polymerlagen ausgebildet sein. Auch kann das optische Element ein Reaktionsharz, etwa ein Epoxid- oder ein Acrylharz, Silikonharze oder ein Silikon enthalten. Das optische Element kann weiterhin mit einer Vergütungsschicht beschichtet sein.

In einer weiteren bevorzugten Ausgestaltung der Erfindung ist das optische Element ein refraktives Element, ein diffraktives Element oder ein dispersives Element. Die Strahlformung erfolgt bei refraktiven Elementen durch Brechung, gegebenenfalls über einen ortsabhängigen Brechungsindex (GRIN: GRadienten INdex), bei diffraktiven Elementen durch Beugung und bei dispersiven Elementen durch die Wellenlängenabhängigkeit des Brechungsindizes. Gegebenenfalls kann das optische Element als holographische oder geometrische Optik ausgebildet sein. Unter einer geometrischen Optik wird insbesondere ein refraktives oder reflektives optisches Element verstanden, das eine entsprechende Formung von brechenden bzw. reflektierenden (Ober)Flächen des Elements zur Strahlformung ausnutzt. Insbesondere kann eine derartige Optik nach den Prinzipien der geometrischen Optik (Strahlenoptik) behandelt werden. Unter einer holographischen Optik wird insbesondere ein wellenoptisches Element verstanden, das die Wellennatur von Strahlung zur Strahlformung ausnutzt und dementsprechend im Wesentlichen nicht oder nur stark erschwert im Rahmen der geometrischen Optik behandelt werden kann. Eine derartige Optik kann beispielsweise ein geometrisches optisches Element, etwa einen Spiegel oder eine Linse, ersetzen. Holographische optische Elemente können weiterhin verglichen mit entsprechenden geometrischen Optiken oftmals kostengünstiger gefertigt werden.

Beispielsweise ist das optische Element als Linse, etwa diffraktive oder refraktive Linse, oder Reflektor, vorzugsweise jeweils mit einem Fokus oder Fokalbereich, ausgebildet, der einem Halbleiterchip des optoelektronischen Bauteils zugeordnet ist.

Gemäß einer weiteren bevorzugten Ausgestaltung der Erfindung ist das optische Element reversibel oder irreversibel an der Vorrichtung befestigt. Eine reversible Befestigung erleichtert den Austausch eines optischen Elements bei einer bereits am Gehäusekörper eines optoelektronischen Bauteils befestigten Vorrichtung, wohingegen eine irreversible Befestigung sich durch erhöhte mechanische Belastbarkeit auszeichnet.

Die Vorrichtung umfasst einen Rahmen, der zur Aufnahme des optischen Elements bestimmt ist. Beispielsweise weist der Rahmen in Aufsicht eine kreisförmige oder mehreckige, insbesondere viereckige oder sechseckige, einhüllende Grundform oder einen kreisförmigen oder mehreckigen, insbesondere viereckigen oder sechseckigen, Umriss auf.

Der Rahmen kann, vorzugsweise innenseitig, eine Halterungsvorrichtung aufweisen, die zur Befestigung des optischen Elements an der Vorrichtung ausgebildet ist. Bevorzugt ist im Rahmen eine Nut ausgebildet, besonders bevorzugt eine innenseitig umlaufende Nut, in die ein Vorsprung des optischen Elements eingreift. Die Stabilität der Befestigung des optischen Elements an der Vorrichtung kann so erhöht werden. Es kann jedoch eine von einer Nut verschiedene Halterungsvorrichtung, beispielsweise eine Rastvorrichtung, die eine lösbare Befestigung des optischen Elements an der Vorrichtung erleichtert, am Rahmen zur Befestigung des optischen Elements, das vorzugsweise ein entsprechend der jeweiligen Halterungsvorrichtung ausgebildetes Halterungselement aufweist, vorgesehen sein.

In einer weiteren bevorzugten Ausgestaltung der Erfindung ist die Vorrichtung mittels Spritzguss, Pressguss oder Spritzpressguss mit einer geeigneten Gussmasse, vorzugsweise einen Kunststoff enthaltend, hergestellt. Derartige Verfahren sind zur Herstellung hoher Stückzahlen von Vorrichtungen besonders geeignet.

Gemäß der Erfindung ist das Befestigungselement am Rahmen angeordnet und/oder befestigt.

Das Befestigungselement ist stiftartig ausgeführt.

In einer vorteilhaften Weiterbildung der Erfindung ist die Vorrichtung einstückig ausgebildet. Insbesondere können Rahmen und Befestigungselement in einer durchgehenden Struktur ausgebildet sein, wodurch die Stabilität der Verbindung von Befestigungselement und Rahmen vorteilhaft erhöht und die Herstellung der Vorrichtung vereinfacht wird.

In einer weiteren bevorzugten Ausgestaltung der Erfindung umfasst die Vorrichtung eine Mehrzahl von, vorzugsweise gleichartigen, Befestigungselementen. Mittels einer Mehrzahl von Befestigungselementen kann die Stabilität der Befestigung der Vorrichtung am Gehäusekörper vorteilhaft erhöht werden. Bevorzugt sind die Befestigungselemente bei einer mehreckigen Grundform oder Umriss in den Eckbereichen des Rahmens angeordnet. Besonders bevorzugt entspricht die Anzahl der Befestigungselemente der Anzahl an Ecken. Bei einer kreisförmigen Grundform des Rahmens hat sich eine Anzahl von drei oder vier Befestigungselementen als ausreichend erwiesen.

Ein erfindungsgemäßes Bauelement umfasst ein optoelektronisches Bauteil und eine erfindungsgemäße Vorrichtung, wobei das optoelektronische Bauteil zumindest einen Halbleiterchip und einen Gehäusekörper umfasst.

Der Halbleiterchip ist als Lumineszenzdiodenchip zur Strahlungserzeugung ausgebildet. Das optische Element dient mit Vorzug der Strahlformung vom Halbleiterchip erzeugter Strahlung.

In einer weiteren bevorzugten Ausgestaltung der Erfindung ist das Bauelement und/oder das optoelektronische Bauteil oberflächenmontierbar (SMD: Surface Mountable Device), zum Beispiel zur Montage auf einer Leiterplatte, vorzugsweise mittels Löten, ausgebildet.

In einer vorteilhaften Weiterbildung der Erfindung ist die Vorrichtung nach der Montage des optoelektronischen Bauteils auf einer Leiterplatte am Gehäusekörper des Bauteils befestigt. Dies erleichtert den Einsatz von Materialien für die Vorrichtung und/oder das optische Element, die, wie zum Beispiel Thermoplast-Materialien, bei typischen Löttemperaturen zur Verformung neigen.

In einer weiteren vorteilhaften Weiterbildung der Erfindung ist die Vorrichtung, vorzugsweise mit dem von der Vorrichtung gehaltenen optischen Element, vor der Montage des Bauelements am Gehäusekörper des optoelektronischen Bauteils befestigt. Gegebenenfalls kann das optische Element auch nach der Befestigung der Vorrichtung am Gehäusekörper in der Halterung angeordnet werden.

Bevorzugt ist die Vorrichtung an die Form des Gehäusekörpers angepasst. Besonders bevorzugt weisen der Gehäusekörper und die Vorrichtung bzw. der Rahmen, insbesondere in Aufsicht, eine ähnliche, vorzugsweise übereinstimmende, einhüllende Grundform oder Umriss auf. Ein Bestückungsautomat zur Positionierung der Bauelemente auf einer Leiterplatte kann gegenüber einer andersartigen Formgebung der Vorrichtung mit Vorteil gegenüber einer Bestückung einer Leiterplatte mit optoelektronischen Bauteilen ohne maßgebliche Änderung der Prozessparameter - etwa Parametern zur Erkennung eines Bauelements - betrieben werden.

Gemäß der Erfindung ist der Halbleiterchip zur Strahlungserzeugung kurzwelliger Strahlung im blauen oder ultravioletten Spektralbereich vorgesehen. Bevorzugt liegt eine Peakwellenlänge der vom Halbleiterchip zu erzeugenden Strahlung in einem Wellenlängenbereich kleiner 527 nm, besonders bevorzugt kleiner 500 nm oder kleiner 480 nm. Derart kurzwellige Strahlung kann bei herkömmlich verwendeten Linsen bereits zu Degradationserscheinungen führen, die aufgrund der Vorrichtung, die sich durch eine hohe Flexibilität bezüglich des einsetzbaren optischen Elements auszeichnet, vorteilhaft verringert werden können.

Mittels der Vorrichtung mit einem gegenüber kurzwelliger Strahlung stabilen optischen Element kann bei einem Bauelement vereinfacht eine effiziente, dauerhaft stabile, Strahlformung einer vom Halbleiterchip erzeugten Strahlung auch bei kurzwelliger, insbesondere blauer oder ultravioletter, Strahlung hoher Intensität erzielt werden.

In einer weiteren bevorzugten Ausgestaltung der Erfindung ist der Halbleiterchip in eine Umhüllungsmasse eingebettet. Mit Vorteil schützt die Umhüllungsmasse den Halbleiterchip vor schädlichen äußeren Einwirkungen, wie Feuchtigkeit.

In einer weiteren bevorzugten Ausgestaltung der Erfindung ist das optoelektronische Bauteil zur Erzeugung mischfarbigen, insbesondere weißen, Lichts, ausgebildet. Zur Erzeugung mischfarbigen Lichts ist dem Halbleiterchip beispielsweise ein Lumineszenzkonversionsmaterial, etwa ein geeigneter Leuchtstoff, nachgeordnet. Der Leuchtstoff kann beispielsweise als Pulver in die Umhüllungsmasse eingebracht sein. Das Lumineszenzkonversionsmaterial konvertiert einen Teil der vom Halbleiterchip erzeugten Strahlung einer ersten Wellenlänge in Strahlung einer zweiten Wellenlänge, die größer als die erste Wellenlänge ist. Aus der Mischung der vom Halbleiterchip emittierten und der lumineszenzkonvertierten Strahlung kann sich mischfarbiges, insbesondere weißes, Licht ergeben. Zur Erzeugung von weißem Licht eignen sich Halbleiterchips, die im blauen oder ultravioletten Spektralbereich emittieren. Diese Strahlung wird von einem Lumineszenzkonversionsmaterial zum Beispiel in gelbe Strahlung umgewandelt.

In einer weiteren bevorzugten Ausgestaltung der Erfindung ist das optische Element von der Umhüllungsmasse beabstandet. Der Abstand ist bevorzugt durch die Ausbildung der Vorrichtung bzw. der Befestigungselemente bestimmt. Besonders bevorzugt sind die Vorrichtung und das optoelektronische Bauteil so aufeinander abgestimmt, dass sich nach dem Befestigen der Vorrichtung am optoelektronischen Bauteil ein definierter Abstand zwischen dem optischen Element und der Umhüllungsmasse einstellt.

In einer weiteren bevorzugten Ausgestaltung der Erfindung grenzt das optische Element an die Umhüllungsmasse an. Hierdurch kann die Größe des Bauelements vorteilhaft verringert und der Schutz des Bauelements vor dem Eindringen von Fremdkörpern erhöht werden.

In einer vorteilhaften Weiterbildung der Erfindung wird das optische Element von der Vorrichtung, insbesondere gegenüber Verformungen der Umhüllungsmasse, im Betrieb des Bauelements relativ zum Halbleiterchip lagestabil gehalten. Die Gefahr von Änderungen in der Abstrahl- oder Empfangscharakteristik des Bauelements aufgrund von Lageänderungen des optischen Elements oder Verformungen der Umhüllungsmasse kann dadurch verringert werden.

Der Gehäusekörper des optoelektronischen Bauteils kann beispielsweise einen Kunststoff enthalten. Der Gehäusekörper ist mittels Spritz-, Spritzpress- oder Pressguss mit einer geeigneten Gussmasse hergestellt.

Gemäß der Erfindung sind die Vorrichtung und der Gehäusekörper in ihrer Zusammensetzung identisch. Thermisch bedingte Verspannungen zwischen der Vorrichtung und dem Gehäusekörper können so weitgehend vermieden werden, wodurch die Stabilität des Bauelements erhöht wird.

Am Gehäusekörper ist mindestens eine Befestigungsvorrichtung zur Befestigung der Vorrichtung mittels des (der) Befestigungselement(e) am Gehäusekörper ausgebildet. Bevorzugt entspricht die Anzahl der Befestigungsvorrichtungen derjenigen der Befestigungselemente, so dass insbesondere eine Mehrzahl von Befestigungsvorrichtungen am Gehäusekörper ausgebildet sein kann. Die Befestigungsvorrichtung(en) ist (sind) im Gehäusekörper vorgeformt.

Die Vorrichtung ist über das (die) Befestigungselement(e) mittels einer Klebeverbindung am Gehäusekörper befestigt.

Die Vorrichtung kann mit oder ohne optischem Element am Gehäusekörper befestigt werden, wobei mit Vorzug eine übermäßige thermische Belastung des optischen Elements vermieden wird bzw. entsprechend temperaturstabile optische Elemente eingesetzt werden.

Die Befestigungsvorrichtung umfasst mindestens eine das Befestigungselement der Vorrichtung aufnehmende Ausnehmung im Gehäusekörper. Alternativ oder zusätzlich umfasst die Befestigungsvorrichtung mindestens eine das Befestigungselement der Vorrichtung aufnehmende Aussparung im Gehäusekörper.

Es sei angemerkt, dass im Rahmen der Erfindung unter Ausnehmung des Gehäusekörpers eine sich von einer Eintrittsfläche in den Gehäusekörper hinein erstreckende Ausnehmung angesehen wird, die keine Austrittsfläche aus dem Gehäusekörper aufweist. Dies ist im Gegensatz zu sehen zu einer Aussparung, welche sich derart durch den Gehäusekörper erstreckt, dass sie eine von der Eintrittsfläche verschiedene Austrittsfläche aufweist. Die Austrittsfläche kann dabei eine der Eintrittsfläche gegenüberliegende Oberfläche oder eine an die Eintrittsfläche angrenzende Oberfläche des Gehäusekörpers sein.

Eine Ausnehmung ist für eine Klebeverbindung besonders geeignet.

In einer weiteren bevorzugten Ausgestaltung der Erfindung weist das optoelektronische Bauteil einen ersten Anschlussleiter und einen zweiten Anschlussleiter zur elektrischen Kontaktierung des Halbleiterchips sowie ein, vorzugsweise von den Anschlussleitern verschiedenes, thermisches Anschlussteil auf. Die Anschlussleiter sind beispielsweise zur Verlötung mit den Leiterbahnen einer Leiterplatte vorgesehen. Über das thermische Anschlussteil kann die im Betrieb am Halbleiterchip anfallende Wärme effizient vom Halbleiterchip abgeleitet werden. Derartige Bauteile sind für Hochleistungs-Halbleiterchips besonders geeignet, die im Betrieb eine vergleichsweise hohe Wärme und Strahlung hoher Intensität erzeugen können. Mittels der Vorrichtung können auch bei Hochleistungsbauelementen auf einfache Weise strahlungsstabile optische Elemente eingesetzt werden.

Weitere Ausgestaltungen, Weiterbildungen, Vorteile und Zweckmäßigkeiten der Erfindung ergeben sich aus der Beschreibung der Ausführungsbeispiele in Verbindung mit den Figuren.

### Es zeigen

Figur 1 eine schematische Darstellung einer Vorrichtung anhand einer perspektivischen Schrägansicht von oben in Figur 1A und einer perspektivischen Schrägansicht von unten in Figur 1B,
Figur 2 eine schematische Darstellung einer Vorrichtung anhand einer perspektivischen Schrägansicht von unten,
Figur 3 eine Abwandlung eines Bauelements anhand einer schematischen Schnittansicht,
Figur 4 eine Abwandlung eines Bauelements anhand einer schematischen Schnittansicht,
Figur 5 ein Ausführungsbeispiel eines erfindungsgemäßen Bauelements anhand einer schematischen Schnittansicht und
Figur 6 eine schematische Darstellung eines weiteren Ausführungsbeispiels eines erfindungsgemäßen Bauelements anhand einer perspektivischen Aufsicht auf ein optoelektronisches Bauteil in Figur 6A und einer perspektivischen Schnittansicht in Figur 6B.

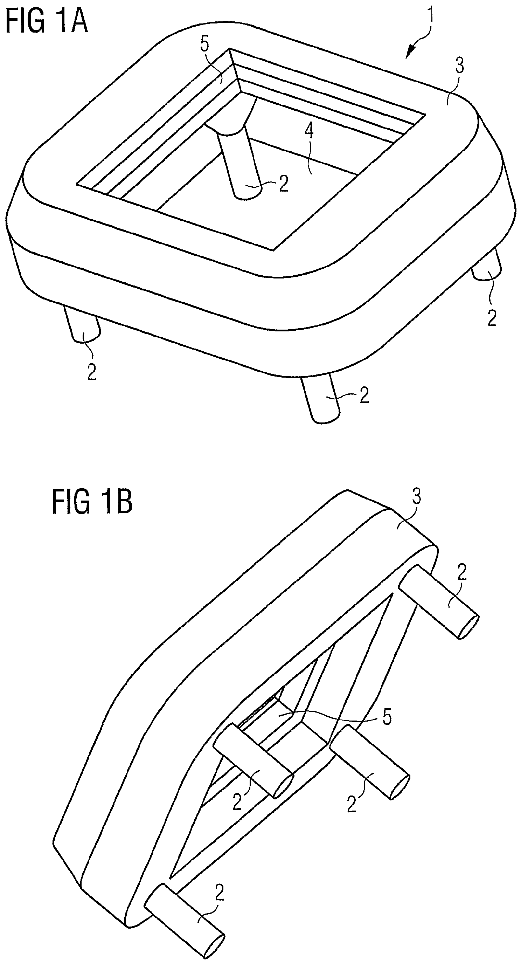

In Figur 1 ist eine Vorrichtung 1 anhand einer perspektivischen Schrägansicht von oben in Figur 1A und einer perspektivischen Schrägansicht von unten in Figur 1B schematisch dargestellt.

Die Vorrichtung 1 umfasst eine Mehrzahl, in diesem Ausführungsbeispiel vier, von Befestigungselementen 2, die zur Befestigung der Vorrichtung an einem Gehäusekörper eines optoelektronischen Bauteils vorgesehen sind. Weiterhin ist die Vorrichtung als Halterung für ein separates optisches Element ausgebildet. Hierzu ist in einem Fenster 4 der Vorrichtung 1, das z.B. durch Aussparen des Rahmens 3 gebildet ist, eine Halterungsvorrichtung 5 für ein separates, vorzugsweise getrennt von der Vorrichtung hergestelltes, optisches Element vorgesehen. Das Fenster 4 kann beispielsweise eine dem Rahmen entsprechende Form, insbesondere rechteckig oder quadratisch, aufweisen. Bevorzugt gehen die Befestigungselemente von Eckbereichen des Rahmens 3 aus.

Die Vorrichtung 1 weist vorzugsweise eine in Aufsicht im Wesentlichen viereckige quadratische oder rechteckige einhüllende Grundform auf, die durch einen, vorzugsweise einstückigen, insbesondere geschlossenen, Rahmen 3, von dem die Befestigungselemente 2 ausgehen, bestimmt ist. Die Befestigungselemente 2 sind vorzugsweise stiftartig, beispielsweise als Passstifte ausgeführt.

Die Halterungsvorrichtung 5 ist beispielsweise als innenseitig im Rahmen umlaufende Nut ausgebildet. Die Befestigungselemente 2 sind vorzugsweise gleichartig ausgebildet und weisen eine für ein Kleben vorgesehene charakteristische Ausgestaltung auf.

Wie in Figur 1B zu erkennen, sind die Befestigungselemente 2 in diesem Ausführungsbeispiel im Wesentlichen zylinderförmig ausgebildet. Die Befestigungselemente greifen in im Gehäusekörper des optoelektronischen Bauteils entsprechend vorgeformte Befestigungsvorrichtungen ein.

Die Vorrichtung kann beispielsweise über Spritz-, Spritzpress- oder Pressguss mit einer geeigneten Gussmasse, vorzugsweise ein Kunststoffmaterial, etwa ein Acryl- oder Epoxid-basierendes Kunststoffmaterial, hergestellt sein. Die Form der Vorrichtung wird durch die beim jeweiligen Gussverfahren eingesetzten Gusswerkzeuge bestimmt. Die Vorrichtung kann einstückig ausgebildet sein, wodurch eine, insbesondere gegenüber thermischen Verspannungen, vorteilhaft stabile Verbindung zwischen den Befestigungselementen und dem Rahmen ausgebildet wird. Gegebenenfalls kann ein optisches Element schon bei der Herstellung der Vorrichtung, etwa durch teilweises Umgießen, in der Vorrichtung gehalten werden.

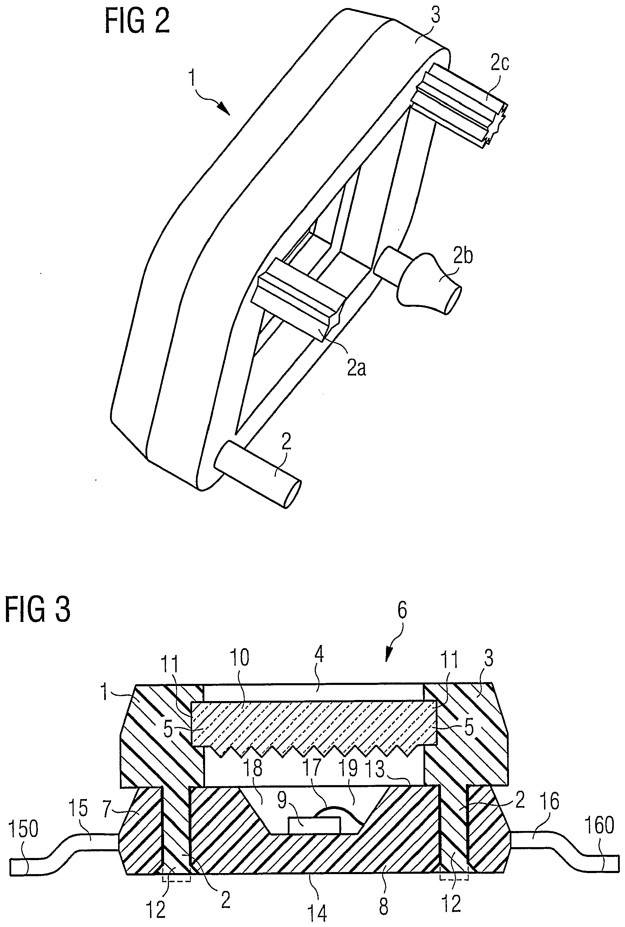

Das in Figur 2 anhand einer perspektivischen Schrägansicht von unten schematisch dargestellte Vorrichtung entspricht im Wesentlichen der in Figur 1 gezeigten Vorrichtung. Unterschiede zeigen sich in der Ausgestaltung der Befestigungselemente.

Die unterschiedlichen Ausgestaltungen der Befestigungselemente in Figur 2, dienen insbesondere der Veranschaulichung möglicher Ausführungsvarianten. Bevorzugt sind die Befestigungselement der Vorrichtung jedoch alle gleichartig ausgeführt.

Das Befestigungselement 2 ist wie in Figur 1 im Wesentlichen zylinderförmig ausgebildet. Die in Figur 2 dargestellten Befestigungselemente 2a, 2b und 2c weisen eine strukturierte Oberfläche auf und sind für eine Klebeverbindung zwischen Vorrichtung und Gehäusekörper des optoelektronischen Bauteils besonders geeignet. Die Oberfläche der Befestigungselemente 2a, 2b und 2c ist gegenüber der Oberfläche des Befestigungselements 2 durch entsprechende Strukturierung vergrößert. Die strukturierte Oberfläche kann durch entsprechende Gusswerkzeuge, geeignetes Abformen oder mechanisches Abdünnen vorgeformter Befestigungselemente erzeugt werden. Die Oberfläche kann beispielsweise Ein-und/oder Ausbuchtungen, bzw. Auswölbungen oder Rillen als Struktur umfassen.

Mit Vorzug sind die verschiedenartigen Befestigungselemente 2, 2a, 2b und 2c zur Befestigung an gleichartig ausgebildeten Befestigungsvorrichtungen des Gehäusekörpers geeignet. Die Herstellung des Gehäusekörpers mit den Befestigungsvorrichtungen kann so mit Vorteil unabhängig von der Ausbildung der Befestigungselemente erfolgen.

Eine große Oberfläche des Befestigungselements bietet eine vorteilhaft große haftvermittelnde Fläche zwischen Befestigungselement und Klebstoff, wodurch die mechanische Stabilität der Befestigung der Vorrichtung am Gehäusekörper mit Vorteil erhöht wird.

In Figur 3 ist eine Abwandlung eines Bauelements 6 anhand einer Schnittansicht schematisch dargestellt.

Das Bauelement 6 umfasst ein optoelektronisches Bauteil 7, mit einem Gehäusekörper 8, einem Halbleiterchip 9 und eine am Gehäusekörper befestigten Vorrichtung 1.

Die Vorrichtung kann im Wesentlichen wie in Figur 1 oder 2 ausgebildet sein, wobei in Figur 3 ein optisches Element 10 von der Halterungsvorrichtung 5 gehalten wird. Hierzu greift ein Halterungselement 11, z.B. ein Vorsprung, des optischen Elements 10 in die Halterungsvorrichtung 5, z.B. eine Nut, ein.

Die Befestigungselemente 2 der Vorrichtung werden bei der Montage der Vorrichtung am Gehäusekörper in entsprechende Befestigungsvorrichtungen 12 des Gehäusekörpers 8 eingeführt, die vorzugsweise schon bei der Herstellung des Gehäusekörpers ausgebildet werden.

Die Befestigungsvorrichtungen 12 sind in diesem Ausführungsbeispiel als Aussparungen ausgebildet, die von einer ersten Hauptfläche 13 des Gehäusekörpers durch den Gehäusekörper bis zu einer der ersten Hauptfläche gegenüberliegenden zweiten Hauptfläche 14 des Gehäusekörpers reichen.

Weiterhin sind die Befestigungsvorrichtungen ebenso wie die Befestigungselemente in diesem Ausführungsbeispiel zur thermischen Vernietung ausgebildet. Hierbei ragt das Befestigungselement nach dem Einführen in die Befestigungsvorrichtung seitens der zweiten Hauptfläche des Gehäusekörpers 14 über die zweite Hauptfläche hinaus, was in Figur 3 gestrichelt angedeutet ist. In dem herausragenden Teilstück des Befestigungselements 2 wird das Befestigungselement nachfolgend derart erhitzt, dass es zumindest in diesem Teilbereich fließfähig wird. Das fließfähige Teilstück formt sich ("fließt") an die Befestigungsvorrichtung an, so dass sich nach dem Abkühlen und dem erstarren des Befestigungselements eine mechanisch stabile Befestigung ausbildet.

Gegebenenfalls kann auch der Gehäusekörper im an die Befestigungsvorrichtung seitens der zweiten Hauptfläche angrenzenden Bereich erhitzt werden, so dass der Gehäusekörper und das fließfähige Befestigungselement verschmelzen.

Die laterale Ausdehnung der Befestigungsvorrichtung 12 ist seitens der zweiten Hauptfläche mit Vorzug größer als die des Befestigungselements 2, und verringert sich in Richtung der ersten Hauptfläche. Das nach dem Einführen des Befestigungselements in die Befestigungsvorrichtung freie Volumen ist zur Aufnahme des vor dem Erhitzen des Befestigungselements über die zweite Hauptfläche überstehenden Materials bestimmt.

Zu diesem Zwecke ist die Befestigungsvorrichtung beispielsweise im Bereich angrenzend an die zweite Hauptfläche des Gehäusekörpers vorzugsweise mit einem trapezförmigen sich in Richtung der ersten Hauptfläche verjüngenden Querschnitt ausgebildet und erstreckt sich nach der Verjüngung im Wesentlichen zylinderförmig in Richtung der ersten Hauptfläche.

Zur Erhöhung der mechanischen Stabilität der Befestigung der Vorrichtung am Gehäusekörper ist die Vorrichtung bevorzugt so ausgebildet oder erfolgt die Befestigung derart, dass der Rahmen seitens der ersten Hauptfläche des Gehäusekörpers auf diesem aufliegt. Besonders bevorzugt sind die Vorrichtung und der Gehäusekörper so aneinander angepasst, dass nach der thermischen Vernietung seitens der zweiten Hauptfläche eine im Wesentlichen ebene Oberfläche des Gehäusekörpers gebildet wird.

Das optoelektronische Bauteil 7 weist einen ersten Anschlussleiter 15 und einen zweiten Anschlussleiter 16 auf, die an, vorzugsweise verschiedenen, Seitenflächen des Gehäusekörpers aus diesem herausragen. Die Anschlussleiter sind vorzugsweise als Teile eines Leiterrahmens auszubilden und dienen der elektrischen Kontaktierung des Halbleiterchips, beispielsweise eines Lumineszenzdiodenchips. Der Halbleiterchip 9 kann mit dem ersten Anschlussleiter 15 über eine elektrisch leitfähige Klebe- oder eine Lötverbindung elektrisch leitend verbunden und auf diesem befestigt sein. Zur elektrisch leitenden Verbindung mit dem zweiten Anschlussleiter 16 dient ein Bonddraht 17. Diese leitenden Verbindungen und die Anordnung des Halbleiterchips auf dem Anschlussleiter 15 ist in Figur 3 nicht explizit dargestellt.

Das optoelektronische Bauteil kann mittels Umgießen, etwa im Spritzgussverfahren, eines die beiden Anschlussleiter 15 und 16 umfassenden Leiterrahmens mit einer geeigneten Gussmasse, etwa ein Kunststoffmaterial auf Epoxid- oder Acryl-Basis, hergestellt werden. Der Gehäusekörper weist bevorzugt eine Kavität 18 auf, in der der Halbleiterchip 9 angeordnet ist. Weiterhin kann in der Kavität 18 eine Umhüllungsmasse 19, etwa ein Silikon enthaltend, angeordnet sein, die den Halbleiterchip zumindest teilweise umformt und diesen vor schädlichen äußeren Einflüssen schützt.

Das optoelektronische Bauteil ist zur Strahlungserzeugung ausgebildet. Besonders bevorzugt erzeugt das optoelektronische Bauteil 7 mischfarbiges, insbesondere weißes, Licht. Der Halbleiterchip 9 ist zur Strahlungserzeugung im ultravioletten oder blauen Spektralbereich geeignet. Zweckmäßigerweise basiert der Halbleiterchip hierzu auf GaN.

Zur Erzeugung mischfarbigen Lichts regt ein Teil der vom Halbleiterchip erzeugten, kurzwelligen, blauen oder ultravioletten, Strahlung ein in der Umhüllungsmasse 19 angeordnetes Lumineszenzkonversionsmaterial, etwa einen Leuchtstoff, zur Emission längerwelliger, z.B. gelber, Strahlung an. Aus der Mischung der vom Halbleiterchip erzeugten und der vom Lumineszenzkonversionsmaterial reemittierten Strahlung kann in der Folge mischfarbiges, insbesondere weißes Licht entstehen.

Zur Erhöhung der Effizienz des optoelektronischen Bauteils können die Wände der Ausnehmung mit einem reflexionssteigernden Material, etwa einem Metall, beschichtet sein.

Vom optoelektronischen Bauteil erzeugte Strahlung trifft auf das optische Element 10, das aufgrund der Vorrichtung mit einer vorteilhaften hohen UV-Stabilität ausgebildet sein kann und aus Glas ist. Das optische Element 10 dient der Strahlformung der vom optoelektronischen Bauteil her auftreffenden Strahlung und ist beispielsweise als refraktive Linse, etwa als Fresnellinse, ausgebildet. Die Strahlformung erfolgt in Figur 3 über die Fresnelstruktur auf der dem Halbleiterchip zugewandten Seite des optischen Elements 10.

Mit Vorzug überspannt das optische Element 10 oder das Fenster 4 den Bereich der Kavität vollständig, so dass ein möglichst hoher Anteil an vom optoelektronischen Bauteil erzeugter Strahlung der Strahlformung durch das optische Element zugänglich ist.

Über eine wie in Figur 3 gezeigte fresnellinsenartige Struktur auf der dem Halbleiterchip zugewandten Seite etwa, kann ein Parallelisierung in ein Parallelbündel der vom Bauelement emittierten Strahlung erzielt werden.

Aufgrund der mechanisch stabilen Verbindung von Vorrichtung und Gehäusekörper ist die Gefahr von Änderungen der Strahlungsemissionseigenschaften, insbesondere der Abstrahlcharakteristik, des Bauelements verringert.

Ferner können Materialien für das optische Element eingesetzt werden, die eine hohe UV-Stabilität aufweisen und für herkömmliche optoelektronische Bauteile nur schwer anwendbar sind, weil sie etwa schlecht auf der Umhüllungsmasse haften oder einen stark von der Umhüllungsmasse abweichenden thermischen Ausdehnungskoeffizienten aufweisen, so dass die Gefahr einer Delamination des geklebten optischen Elements von der Umhüllungsmasse erhöht würde.

Unterschiede im thermischen Ausdehnungskoeffizienten zwischen optischem Element und der Vorrichtung können in der Ausgestaltung der Vorrichtung, insbesondere der Halterungsvorrichtung, berücksichtig werden.

Die Gefahr thermischer Verspannungen zwischen der Vorrichtung und dem Gehäusekörper ist dadurch verringert, dass identische

Materialien für den Gehäusekörper und die Vorrichtung Anwendung finden.

Das Bauelement beziehungsweise das optoelektronische Bauteil ist in diesem Ausführungsbeispiel oberflächenmontierbar ausgebildet. Hierzu werden beispielsweise die Anschlussleiter 15 und 16 seitens von Lötflächen 150 bzw.160 der Anschlussleiter 15 bzw. 16 auf Leiterbahnen einer Leiterplatte (nicht dargestellt) gelötet.

Bei einer wie in Figur 3 dargestellten thermischen Vernietung seitens der zweiten Hauptfläche 14 des Gehäusekörpers 8 ist die Vorrichtung mit Vorteil schon vor der Montage des Bauelements auf der Leiterplatte am Gehäusekörper befestigt, so dass das Bauelement mit dem optoelektronischen Bauteil und der thermisch vernieteten Vorrichtung oberflächenmontierbar ist.

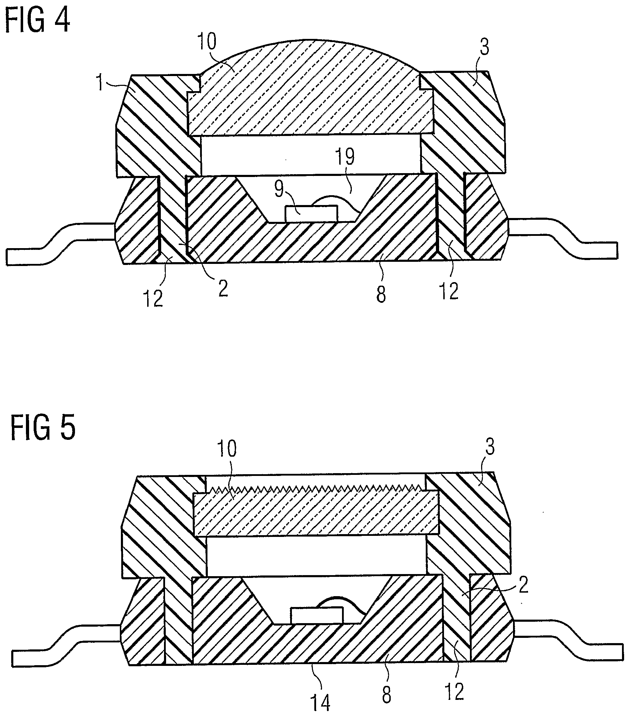

In Figur 4 ist eine Abwandlung eines Bauelements anhand einer Schnittansicht schematisch dargestellt. Im Wesentlichen entspricht dieses Ausführungsbeispiel dem in Figur 3 gezeigt. Im Unterschied hierzu ist in Figur 4 ein refraktives optisches Element 10 , das auf der dem Halbleiterchip 9 abgewandten Seite nach Art einer Linse gekrümmt ist vorgesehen. Seitens des Halbleiterchips 9 ist das optische Element mit Vorzug im Wesentlichen eben ausgeführt. Über eine derartige Linse kann die vom Halbleiterchip, der vorzugsweise im Fokus angeordnet ist, erzeugte Strahlung oder auf diesen einfallende Strahlung fokussiert werden.

Das optische Element ist in Figur 4 als von dem Gehäusekörper beziehungsweise der Umhüllungsmasse 19 beabstandet dargestellt.

Gegebenenfalls kann das optische Element jedoch auch in direktem Kontakt mit dem Gehäusekörper 8 beziehungsweise der Umhüllungsmasse 19, sein. Das optische Element wird hierbei vorteilhafterweise von der Vorrichtung derart stabil gehalten, dass die relative Lage von optischem Element und Halbleiterchip im Betrieb des Bauelements, insbesondere gegenüber Verformungen der Umhüllung, im Wesentlichen unverändert bleibt.

Weiterhin kann die Vorrichtung so ausgebildet sein, dass sie in Aufsicht in ihrer Form im Wesentlichen der des optoelektronischen Bauteils entspricht. Die Bilderkennung derartiger Bauelemente in Bestückungsautomaten zur Anordnung der Bauelemente auf einer Leiterplatte kann so mit Vorteil mit den gleichen Prozessparametern erfolgen wie bei optoelektronischen Bauteilen ohne Vorrichtung.

In Figur 5 ist ein Ausführungsbeispiel eines erfindungsgemäßen Bauelements anhand einer Schnittansicht schematisch dargestellt. Unterschiede zur Abwandlung gemäß Figur 3 zeigen sich in der auf der dem Halbleiterchip gegenüberliegenden Seite vorgesehenen Fresnelstruktur und der Art der Befestigung der Vorrichtung am Gehäusekörper 8.

Die Vorrichtung ist am Gehäusekörper 8 mittels einer Klebeverbindung befestigt. Die Befestigungsvorrichtung ist als Ausnehmung ausgeführt. Eine strukturierte Oberfläche etwa gemäß den Befestigungselementen 2a, 2b und 2c aus Figur 2 vergrößert mit Vorteil die haftvermittelnde Fläche zu einem Klebstoff.

Weiterhin kann das optische Element auch als diffraktives Element ausgebildet sein. Hierzu ist beispielsweise ein Träger, etwa aus Glas, vorgesehen, auf den eine Mehrzahl von Polymerschichten aufgebracht sind, in die eine Struktur für die diffraktive Optik eingestempelt ist.

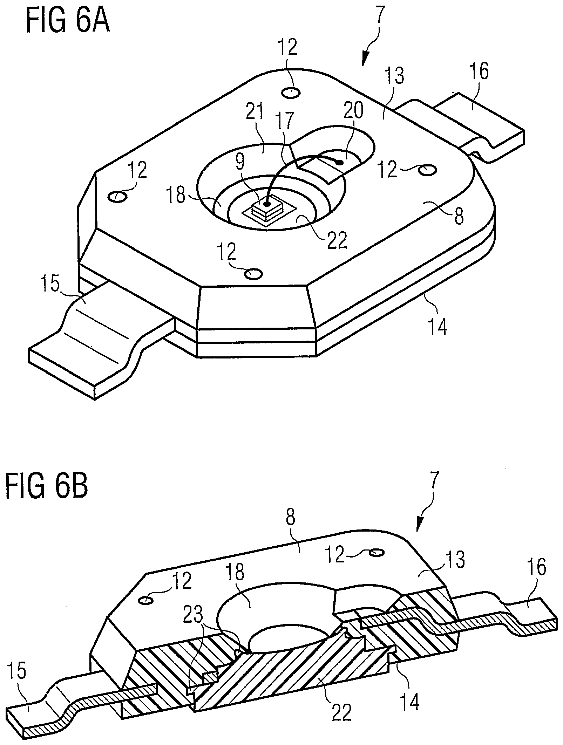

In Figur 6 ist ein weiteres Ausführungsbeispiel eines erfindungsgemäßen Bauelements anhand einer perspektivischen Aufsicht auf ein optoelektronisches Bauteil in Figur 6A und einer perspektivischen Schnittansicht des Bauteils in Figur 6B schematisch dargestellt. Derartige optoelektronische Bauteile sind beispielsweise in der WO 02/084749 A2 näher beschrieben.

Das optoelektronische Bauteil 7 umfasst einen ersten Anschlussleiter 15 und einen zweiten Anschlussleiter 16, die aus den Seitenflächen des Gehäusekörpers 8 des optoelektronischen Bauteils 7 herausragen und beispielsweise schwingenartig ausgebildet sind.

Der Gehäusekörper 8 weist eine Kavität 18 auf, in der der Halbleiterchip 9 angeordnet ist. Der Halbleiterchip 9 ist mit dem Anschlussleiter 15 beispielsweise mittels einer Lötverbindung elektrisch leitend verbunden. Eine leitende Verbindung zum zweiten Anschlussleiter 16 wird über den Bonddrahts 17 hergestellt. Der Anschluss des Bonddrahts an den zweiten Anschlussleiter 16 erfolgt mit Vorzug im Bereich einer Ausbuchtung 20 einer Wand 21 der Kavität 18.

Der Halbleiterchip 9 ist auf einem thermisches Anschlussteil 22 angeordnet, das als Chipträger fungiert. Das thermische Anschlussteil erstreckt sich in vertikaler Richtung von der Kavität bis zur zweiten Hauptfläche 14 des Gehäusekörpers 8 und erleichtert mit Vorteil einen, vorzugsweise großflächigen, thermischen Anschluss des Halbleiterchips seitens der zweiten Hauptfläche an einen externen Kühlkörper. Die thermische Belastung des Gehäusekörpers kann so insbesondere bei Betrieb des Bauteils mit einem Hochleistungs-Halbleiterchip verringert werden.

Das thermische Anschlussteil ist beispielsweise in eine Lasche des ersten Anschlussleiters 15 eingeknüpft oder anderweitig mit dem ersten Anschlussleiter, insbesondere elektrisch leitend und/oder mechanisch, verbunden. Der zweite Anschlussleiter 16, der zur Kontaktierung mit dem Bonddraht vorgesehen ist, ist vorzugsweise bezüglich der Chipmontage-Ebene des Halbleiterchips 9 auf dem thermischen Anschlussteil 22 erhöht. Die für eine Reflexion von Strahlung zur Verfügung stehende Fläche der Wand der Kavität wird so vorteilhaft groß gehalten. Weiterhin kann das thermische Anschlussteil selbst reflektierend ausgeführt sein und bildet dann mit Vorzug einen Teil des Bodens oder der Wand der Kavität. Das thermische Anschlussteil kann ferner seitens der zweiten Hauptfläche aus dem Gehäusekörper herausragen oder im Wesentlichen eben mit dem Gehäusekörper abschließen. Beispielsweise enthält das thermische Anschlussteil ein Metall hoher Wärmeleitfähigkeit, etwa Cu oder Al, oder eine Legierung etwa eine CuWo-Legierung.

Ein Leiterrahmen mit den beiden Anschlussleitern 15 und 16 und dem thermischen Anschlussteil 22 kann bei der Herstellung eines derartigen optoelektronischen Bauteils in einem geeigneten Gussverfahren umgossen werden. Das thermische Anschlussteil 22 ist vorzugsweise mit einer oder mehreren Ausbuchtungen oder Auswölbungen 23 ausgebildet, wodurch die mechanische Anbindung des thermischen Anschlussteils an den Gehäusekörper verbessert und somit die Gesamtstabilität des optoelektronischen Bauteils erhöht wird.

Seitens der ersten Hauptfläche 13 des Gehäusekörpers sind Befestigungsvorrichtungen 12 ausgebildet, die zur Befestigung der Vorrichtung (nicht dargestellt), die beispielsweise entsprechend den vorhergehenden Figuren ausgeführt sein kann, vorgesehen sind. Zur Befestigung der Vorrichtung am Gehäusekörper 8 können beispielsweise vier Befestigungsvorrichtungen 12 vorgesehen sein.

Insgesamt ermöglicht eine Vorrichtung gemäß der vorliegenden Erfindung den Einsatz sehr strahlungsstabiler optischer Elemente und eine hohe Flexibilität bezüglich der Ausgestaltung der optischen Elemente, die durch eine reversible Befestigung bzw. Halterung der optischen Elemente an der Vorrichtung, die einen Austausch der optischen Elemente ohne Beschädigung der Halterung erlaubt, noch erhöht werden kann. Ferner kann der Justageaufwand für ein optisches Element gering gehalten werden, da die relative Lage des Halbleiterchips und des optischen Elements zueinander im Wesentlichen schon bei der Fertigung des Gehäusekörpers bzw. der Vorrichtung bestimmt wird. Besonders eignet sich eine Vorrichtung gemäß der Erfindung für ein Bauelement, das als Blitzlicht, etwa zur Anwendung in einem Mobiltelephon, ausgebildet ist. Als optoelektronisches Bauteil ist insbesondere ein Bauteil ähnlich dem mit der Typenbezeichnung LW W5SG (Hersteller: OSRAM Opto Semiconductors GmbH) oder damit verwandte Bauteile des gleichen Herstellers geeignet.

## Patentansprüche

1. Bauelement (6) mit
- einem optoelektronischen Bauteil (7), das zumindest einen Halbleiterchip (9) und einen Gehäusekörper (8) aufweist und der Halbleiterchip (9) zur Strahlungserzeugung kurzwelliger Strahlung im blauen oder ultravioletten Spektralbereich, vorgesehen ist,
- einer Vorrichtung (1) mit mindestens einem Befestigungselement (2), wobei die Vorrichtung an dem Gehäusekörper (8) des optoelektronischen Bauteils (7) über das Befestigungselement (2) befestigt ist, und
- einem separaten optischen Element, wobei
- die Vorrichtung (1) einen Rahmen (3) umfasst, der zur Aufnahme des optischen Elements bestimmt ist und an welchem das Befestigungselement (2) angeordnet ist und das Befestigungselement (2) stiftartig ausgeführt ist,
- der Gehäusekörper eine Kavität (18) aufweist, in der der Halbleiterchip angeordnet ist,
- an dem Gehäusekörper (8) mindestens eine Befestigungsvorrichtung (12) zur Befestigung der Vorrichtung (1) mittels des Befestigungselements (2) am Gehäusekörper ausgebildet ist,
- die Befestigungsvorrichtung (12) mindestens eine das Befestigungselement (2) der Vorrichtung (1) aufnehmende Ausnehmung oder Aussparung im Gehäusekörper umfasst,
- die Vorrichtung über das Befestigungselement mittels einer Klebeverbindung am Gehäusekörper (8) befestigt ist,
- der Gehäusekörper (8) mittels Spritzguss, Pressguss oder Spritzpressguss hergestellt ist,
- die Vorrichtung (1) und der Gehäusekörper (8) in ihrer Materialzusammensetzung identisch sind,
- und die Vorrichtung (1) als Halterung für das separate optisches Element (10) ausgebildet ist.

2. Bauelement nach Anspruch 1,
**dadurch gekennzeichnet, dass**
das optische Element (10) und/oder die Vorrichtung (1) formstabil unter Einwirkung kurzwelliger, insbesondere blauer oder ultravioletter, Strahlung ist, für deren Erzeugung das optoelektronische Bauteil vorgesehen ist.

3. Bauelement nach Anspruch 1 oder 2,
**dadurch gekennzeichnet, dass**
das optische Element (10) unter Einwirkung kurzwelliger, insbesondere blauer oder ultravioletter, Strahlung, für deren Erzeugung das optoelektronische Bauteil vorgesehen ist, stabil gegenüber Trübungen oder Verfärbungen ist.

4. Bauelement nach mindestens einem der vorhergehenden Ansprüche,
**dadurch gekennzeichnet, dass**
das optische Element (10) ein refraktives Element, ein diffraktives Element oder ein dispersives Element ist.

5. Bauelement nach mindestens einem der vorhergehenden Ansprüche,
**dadurch gekennzeichnet, dass**
das optische Element (10) ein Glas, ein Epoxidmaterial, ein Thermoplast, ein Polymer oder Urethan enthält.

6. Bauelement nach mindestens einem der vorhergehenden Ansprüche,
**dadurch gekennzeichnet, dass**
das optische Element reversibel an der Vorrichtung (1) befestigt ist.

7. Bauelement nach mindestens einem der vorhergehenden Ansprüche,
**dadurch gekennzeichnet, dass**
das optische Element (10) irreversibel an der Vorrichtung (1) befestigt ist.

8. Bauelement nach einem der vorhergehenden Ansprüche,
**dadurch gekennzeichnet, dass**
im Rahmen (3) eine Nut (5) ausgebildet ist, in die ein Vorsprung (11) des optischen Elements (10) eingreift.

9. Bauelement nach einem der vorhergehenden Ansprüche,
**dadurch gekennzeichnet, dass**
der Rahmen (3) in Aufsicht eine kreisförmige oder mehreckige, insbesondere viereckige oder sechseckige, einhüllende Grundform oder einen kreisförmigen oder mehreckigen, insbesondere viereckigen oder sechseckigen, Umriss aufweist.

10. Bauelement nach mindestens einem der vorhergehenden Ansprüche,
**dadurch gekennzeichnet, dass**
die Vorrichtung (1) einstückig ausgebildet ist.

11. Bauelement nach mindestens einem der vorhergehenden Ansprüche,
**dadurch gekennzeichnet, dass**
die Vorrichtung (1) mittels Spritzguss, Pressguss oder Spritzpressguss hergestellt ist.

12. Bauelement nach mindestens einem der vorhergehenden Ansprüche,
**dadurch gekennzeichnet, dass**
die Vorrichtung (1) eine Mehrzahl von, vorzugsweise gleichartigen, Befestigungselementen (2) umfasst.

13. Bauelement nach einem der vorhergehenden Ansprüche,
**dadurch gekennzeichnet, dass**
der Halbleiterchip (9) in eine Umhüllungsmasse (19) eingebettet ist.

14. Bauelement nach dem vorhergehenden Anspruch,
**dadurch gekennzeichnet, dass**
das optische Element (10) von der Umhüllungsmasse (19) beabstandet ist.

15. Bauelement nach einem der beiden vorhergehenden Ansprüche,
**dadurch gekennzeichnet, dass**
das optische Element (10) an die Umhüllungsmasse (19) angrenzt.

16. Bauelement nach einem der Ansprüche 13 bis 15,
**dadurch gekennzeichnet, dass**
das optische Element (10) von der Vorrichtung (1), insbesondere gegenüber Verformungen der Umhüllungsmasse, im Betrieb des Bauelements (6) relativ zum Halbleiterchip (9) lagestabil gehalten wird.

17. Bauelement nach einem der vorhergehenden Ansprüche,
**dadurch gekennzeichnet, dass**
das Bauelement (6) und/oder das optoelektronische Bauteil (7) oberflächenmontierbar ausgebildet ist.

18. Bauelement nach einem der vorhergehenden Ansprüche,
**dadurch gekennzeichnet, dass**
das optoelektronische Bauteil (7) einen ersten Anschlussleiter (15) und einen zweiten Anschlussleiter (16) zur elektrischen Kontaktierung des Halbleiterchips sowie ein thermisches Anschlussteil (22) aufweist.

19. Bauelement nach einem der vorhergehenden Ansprüche,
**dadurch gekennzeichnet, dass**
das Befestigungselement bzw. die Befestigungselemente (2) eine strukturierte Oberfläche aufweisen.

## Claims

1. Component (6) comprising
- an optoelectronic device (7) which has at least one semiconductor chip (9) and a housing body (8) and the semiconductor chip (9) is provided for generating short-wave radiation in the blue or ultraviolet spectral range,
- an apparatus (1) having at least one fastening element (2), wherein the apparatus is fastened on the housing body (8) of the optoelectronic component (7) via the fastening element (2), and
- a separate optical element, wherein
- the apparatus (1) comprises a frame (3) which is intended for accommodating the optical element and on which the fastening element (2) is arranged, and the fastening element (2) is designed in the manner of a pin,
- the housing body has a cavity (18) in which the semiconductor chip is arranged,
- at least one fastening device (12) for fastening the apparatus (1) by means of the fastening element (2) is formed on the housing body,
- the fastening device (12) comprises at least one cavity or recess in the housing body accommodating the fastening element (2) of the apparatus (1),
- the apparatus is fastened to the housing body (8) by means of the fastening element via an adhesive connection,
- the housing body (8) is produced by means of injection molding, compression molding or transfer molding,
- the apparatus (1) and the housing body (8) are identical in terms of their material composition,
- and the apparatus (1) is designed as a holder for the separate optical element (10).

2. The component according to claim 1,
**characterized in that**
the optical element (10) and/or the apparatus are dimensionally stable under the action of short-wave radiation, in particular blue or ultraviolet radiation, for the production of which the optoelectronic device is provided.

3. The component according to claim 1 or 2,
**characterized in that**
the optical element (10) is stable against clouding or discoloration under the action of short-wave radiation, in particular blue or ultraviolet radiation, for the production of which the optoelectronic device is provided.

4. The component according to at least one of the preceding claims,
**characterized in that**
the optical element (10) is a refractive element, a diffractive element or a dispersive element.

5. The component according to at least one of the preceding claims,
**characterized in that**
the optical element (10) contains a glass, an epoxy material, a thermoplastic, a polymer or urethane.

6. The component according to at least one of the preceding claims,
**characterized in that**
the optical element is reversibly fastened to the apparatus (1).

7. The component according to at least one of the preceding claims,
**characterized in that**
the optical element (10) is irreversibly fastened to the apparatus (1).

8. The component according to one of the preceding claims, **characterized in that**
a groove (5) is formed in the frame (3), into which groove (5) a projection (11) of the optical element (10) engages.

9. The component according to one of the preceding claims,
**characterized in that**
the frame (3) in plan view has a circular or polygonal, in particular square or hexagonal, enveloping basic shape or a circular or polygonal, in particular square or hexagonal, contour.

10. The component according to at least one of the preceding claims,
**characterized in that**
the apparatus (1) is formed in one piece.

11. The component according to at least one of the preceding claims,
**characterized in that**
the apparatus (1) is produced by means of injection molding, compression molding or transfer molding.

12. The component according to at least one of the preceding claims,
**characterized in that**
the apparatus (1) comprises a plurality of, preferably identical, fastening elements (2).

13. The component according to one of the preceding claims,
**characterized in that**
the semiconductor chip (9) is embedded in an encapsulation compound (19).

14. The component according to the preceding claim,
**characterized in that**
the optical element (10) is spaced apart from the encapsulation compound (19).

15. The component according to one of the two preceding claims,
**characterized in that**
the optical element (10) adjoins the encapsulation compound (19).

16. The component according to one of claims 13 to 15,
**characterized in that**
during operation of the component, by means of the apparatus (1) the optical element (10) is held in a positionally stable manner relative to the semiconductor chip (9), in particular with respect to deformations of the encapsulation compound.

17. The component according to one of the preceding claims,
**characterized in that**
the component (6) and/or the optoelectronic device (7) is designed to be surface-mountable.

18. The component according to one of the preceding claims,
**characterized in that**
the optoelectronic device (7) comprises a first connection conductor (15) and a second connection conductor (16) for electrically contacting the semiconductor chip and comprises a thermal connection part (22).

19. The component according to one of the preceding claims,
**characterized in that**
the fastening element or the fastening elements has or have a structured surface.

## Revendications

1. Module (6), comprenant
- un composant optoélectronique (7) qui présente au moins une puce à semi-conducteur (9) et un corps de boîtier (8), et la puce à semi-conducteur (9) étant prévue pour générer un rayonnement à courte longueur d'onde dans le domaine spectral bleu ou ultraviolet,
- un dispositif (1) doté d'au moins un élément de fixation (2), le dispositif étant fixé sur le corps de boîtier (8) du composant optoélectronique (7) par l'intermédiaire de l'élément de fixation (2), et
- un élément optique séparé,
- le dispositif (1) comprenant un cadre (3) qui est destiné à loger l'élément optique et sur lequel est disposé l'élément de fixation (2), et l'élément de fixation (2) étant réalisé en forme de tige,
- le corps de boîtier présentant une cavité (18) dans laquelle est disposée la puce à semi-conducteur,
- au moins un dispositif de fixation (12), destiné à fixer le dispositif (1) sur le corps de boîtier au moyen de l'élément de fixation (2), étant réalisé sur le corps de boîtier (8),
- le dispositif de fixation (12) comprenant au moins un évidement ou une encoche logeant l'élément de fixation (2) du dispositif (1) dans le corps de boîtier,
- le dispositif étant fixé sur le corps de boîtier (8) au moyen d'une liaison adhésive par l'intermédiaire de l'élément de fixation,
- le corps de boîtier (8) étant fabriqué par moulage par injection, par moulage par pressage ou par moulage par transfert,
- le dispositif (1) et le corps de boîtier (8) étant identiques dans leur composition de matière,
- et le dispositif (1) étant réalisé comme support pour l'élément optique (10) séparé.

2. Module selon la revendication 1,
**caractérisé en ce que**
l'élément optique (10) et/ou le dispositif (1) sont de forme stable sous l'effet de rayonnement à courte longueur d'onde, notamment bleu ou ultraviolet, pour la génération duquel le composant optoélectronique est prévu.

3. Module selon la revendication 1 ou 2,
**caractérisé en ce que**
l'élément optique (10), sous l'effet de rayonnement à courte longueur d'onde, notamment bleu ou ultraviolet, pour la génération duquel le composant optoélectronique est ménagé, est stable par rapport aux opacités ou décolorations.

4. Module selon au moins l'une quelconque des revendications précédentes,
**caractérisé en ce que**
l'élément optique (10) est un élément réfractif, un élément diffractif ou un élément dispersif.

5. Module selon au moins l'une quelconque des revendications précédentes,
**caractérisé en ce que**
l'élément optique (10) contient un verre, une matière époxy, un thermoplastique, un polymère ou uréthanne.

6. Module selon au moins l'une quelconque des revendications précédentes,
**caractérisé en ce que**
l'élément optique est fixé sur le dispositif (1) de manière réversible.

7. Module selon au moins l'une quelconque des revendications précédentes,
**caractérisé en ce que**
l'élément optique (10) est fixé sur le dispositif (1) de manière irréversible.

8. Module selon l'une quelconque des revendications précédentes,
**caractérisé en ce qu'**
une rainure (5) est réalisée dans le cadre (3), dans laquelle a prise une saillie (11) de l'élément optique (10).

9. Module selon l'une quelconque des revendications précédentes,
**caractérisé en ce que**
le cadre (3), en vue de dessus, présente une forme de base enveloppante, circulaire ou polygonale, notamment carrée ou hexagonale, ou présente un contour circulaire ou polygonal, notamment carré ou hexagonal.

10. Module selon au moins l'une quelconque des revendications précédentes,
**caractérisé en ce que**
le dispositif (1) est réalisé d'une seule pièce.

11. Module selon au moins l'une quelconque des revendications précédentes,
**caractérisé en ce que**
le dispositif (1) est fabriqué par moulage par injection, par moulage par pressage ou par moulage par transfert.

12. Module selon au moins l'une quelconque des revendications précédentes,
**caractérisé en ce que**
le dispositif (1) comprend une pluralité d'éléments de fixation (2) de préférence identiques.

13. Module selon l'une quelconque des revendications précédentes,
**caractérisé en ce que**
la puce à semi-conducteur (9) est incorporée dans une masse d'enrobage (19).

14. Module selon la revendication précédente,
**caractérisé en ce que**
l'élément optique (10) est distancé de la masse d'enrobage (19).

15. Module selon l'une quelconque des deux revendications précédentes,
**caractérisé en ce que**
l'élément optique (10) est adjacent à la masse d'enrobage (19).

16. Module selon l'une quelconque des revendications 13 à 15,
**caractérisé en ce que**
l'élément optique (10), pendant le fonctionnement du module (6), est maintenu par le dispositif (1) de manière stable en position par rapport à la puce à semi-conducteur (9), notamment vis-à-vis de déformations de la masse d'enrobage.

17. Module selon l'une quelconque des revendications précédentes,
**caractérisé en ce que**
le module (6) et/ou le composant optoélectronique (7) sont réalisés de manière à pouvoir être montés en surface.

18. Module selon l'une quelconque des revendications précédentes,
**caractérisé en ce que**
le composant optoélectronique (7) présente un premier conducteur de connexion (15) et un deuxième conducteur de connexion (16) pour la mise en contact électrique de la puce à semi-conducteur, ainsi qu'une pièce de raccordement (22) thermique.

19. Module selon l'une quelconque des revendications précédentes,
**caractérisé en ce que**
l'élément de fixation ou les éléments de fixation (2) présente/présentent une surface structurée.
